# EUROPÄISCHE PATENTANMELDUNG

(11) **EP 1 394 285 A1**
(43) Veröffentlichungstag der Anmeldung: **03.03.2004**
(21) Anmeldenummer: 03405574.9
(22) Anmeldetag: 04.08.2003
(51) Int. Cl.: C23C 16/02, C23C 16/26, C23C 14/02, C23C 14/06

(54) **Substrat mit funktionsschicht**

(30) Priorität: 27.08.2002 EP 02405725
(71) Anmelder: Sulzer Markets and Technology AG, 8401 Winterthur (CH)
(72) Erfinder: Krumeich, Jörg, 8404 Winterthur (CH)
(74) Vertreter: Sulzer Management AG

(57) **Zusammenfassung**

Ein Substrat mit Funktionsschicht umfasst ein Substrat (2) mit einer Oberfläche aus einem organischen Natur- und/oder Kunststoff, eine Funktionsschicht (3) und eine Haftvermittlerschicht (4) zwischen der Oberfläche des Substrates (2) und der Funktionsschicht (3), wobei das Substrat (2) elastisch verformbar ist und die Funktionsschicht (3) als harte Schicht ausgeführt ist, deren Bruchdehnung geringer ist als diejenige des Substrates (2).

## Beschreibung

### Substrat mit Funktionsschicht

Die Erfindung betrifft ein Substrat mit Funktionsschicht gemäss Oberbegriff von Anspruch 1 und ein Verfahren zum Herstellen eines solchen Substrates mit Funktionsschicht.

Die Substrate, die im Zusammenhang mit der vorliegenden Erfindung verwendet werden, haben eine Oberfläche aus einem organischen Naturstoff wie beispielsweise Latex und/oder aus einem Kunststoff wie beispielsweise einem Polymer oder Elastomer. Die Beschichtung eines solchen Substrates mit einer Funktionsschicht scheitert normalerweise, wenn es sich um eine dünne und harte Funktionsschicht handelt, da die vergleichsweise weichen Substrate den dünnen und harten Funktionsschichten keinerlei Stützwirkung geben. Dadurch werden diese bei Belastung eingedrückt, wobei die Funktionsschichten häufig abblättern. Auch eine stärkere Biegung der Substrate führt normalerweise zu einer Zerstörung der dünnen und harten Funktionsschicht. Üblicherweise wird versucht, die elastischen Eigenschaften der Funktionsschicht an diejenigen des Substrates anzupassen, um bei Deformationen des Substrates eine Zerstörung der Funktionsschicht zu vermeiden.

Das Dokument EP-A-1 162 245 beschreibt eine Plastiklinse mit einer harten, kratzfesten Beschichtung. Auf der Plastiklinse ist eine Haftvermittlerschicht vorgesehen und darüber eine harte, kratzfeste Schicht aus Kunstharz, die einen hohen Anteil an Titanoxidpartikeln enthält.

Eine weitere Möglichkeit besteht darin, die Funktionsschichten extrem dünn zu machen. Es ist bekannt, dass Schichten mit einer Dicke von 0.01 bis 0.1 µm wesentlich bruchfester sind als entsprechende dickere Schichten. Insgesamt sind jedoch die Möglichkeiten, Substrate der genannten Art mit einer Funktionsschicht zu versehen, sehr beschränkt, sodass häufig keine optimale Lösung gefunden werden kann.

Aufgabe der Erfindung ist es, ein Substrat mit Funktionsschicht zur Verfügung zu stellen, welches eine Oberfläche aus einem organischen Natur- und/oder Kunststoff aufweist, wobei die Dicke, Zusammensetzung und Härte der Funktionsschicht optimal an eine Aufgabe angepasst werden können trotz unterschiedlicher elastischer Eigenschaften von Funktionsschicht und Substrat. Eine weitere Aufgabe der Erfindung ist es, ein Verfahren zum Herstellen eines solchen Substrates mit Funktionsschicht zur Verfügung zu stellen.

Diese Aufgabe wird erfindungsgemäss durch das in Anspruch 1 definierte Substrat mit Funktionsschicht und das in Anspruch 11 definierte Herstellungsverfahren gelöst.

Das erfindungsgemässe Substrat mit Funktionsschicht umfasst ein Substrat mit einer Oberfläche aus einem organischen Natur- und/oder Kunststoff, eine Funktionsschicht und eine Haftvermittlerschicht zwischen der Oberfläche des Substrates und der Funktionsschicht, wobei das Substrat elastisch verformbar ist und die Funktionsschicht als harte Schicht ausgeführt ist, deren Bruchdehnung geringer ist als diejenige des Substrates. Bei dem organischen Naturstoff der Substratoberfläche kann es sich um einen elastischen Stoff wie beispielsweise Latex handeln und bei dem Kunststoff um ein Polymer wie beispielsweise Polyamid oder ein Elastomer wie beispielsweise Silikongummi. Die Funktionsschicht kann eine Vielzahl von Funktionen, beispielsweise mechanische, physikalische, chemische, biologische oder medizinische Funktionen, erfüllen, wie z.B. niedrige Reibung, Verschleissfestigkeit, Kratzfestigkeit, reflektierende, nichtreflektierende oder farbige Oberflächen, dekorative Effekte, Antihaftbeschichtung, chemisch beständige Oberflächen, biokompatible Oberflächen, blutverträgliche Oberflächen usw.

Vorzugsweise ist die Funktionsschicht derart aufgebaut, dass die Funktionsschicht nach Verformungen des Substrates weiter funktionsfähig ist.

Vorzugsweise ist die Bruchdehnung der Funktionsschicht mindestens um einen Faktor 3 kleiner als diejenige des Substrates und/oder die Funktionsschicht ist kolumnar aufgebaut und weist lediglich eine minimale Bruchdehnung auf. Typischerweise ist die Bruchdehnung der Funktionsschicht kleiner als 1%, 0.5%, 0.2% oder 0.1 % und die Bruchdehnung des Substrates grösser 1 %, 2%, 5%, oder 10%. Vorzugsweise hat die Funktionsschicht eine Dicke von 0.1 bis 10 µm. In einer bevorzugten Ausführungsform ist die Funktionsschicht im Wesentlichen anorganisch aufgebaut und/oder umfasst zumindest einen der folgenden Stoffe: Diamondlike Carbon (DLC), Metalle, Metalllegierungen, oder Metalloxide, - nitride, -carbide, -oxinitride, -carbonitride, -oxicarbide oder -sulfide in unterschiedlichen Stöchiometrien sowie Bilayer mit gradiertem Übergang oder Multilayer.

Vorzugsweise hat die Haftvermittlerschicht eine Dicke von 0.04 bis 0.4 µm. Vorzugsweise haftet die Haftvermittlerschicht derart auf dem Substrat, dass die Funktionsschicht nach Verformungen des Substrates weiter funktionsfähig ist. Vorzugsweise ist die Haftvermittlerschicht chemisch an das Substrat gekoppelt. Vorzugsweise umfasst die Haftvermittlerschicht Diamondlike Carbon (DLC). In einer bevorzugten Ausführungsform enthält die Haftvermittlerschicht Kohlenwasserstoffketten auf der Substratseite und Diamondlike Carbon (DLC) auf der Seite der Funktionsschicht sowie einen gradierten Übergang zwischen Kohlenwasserstoffketten und Diamondlike Carbon (DLC). Die in der bevorzugten Ausführungsform beschriebene Haftvermittlerschicht und deren Herstellung stellt eine eigenständige und unabhängige Erfindung dar, die in einer eigenen Patentanmeldung geschützt werden kann.

In dem erfindungsgemässe Verfahren zum Herstellen eines Substrates mit Funktionsschicht wird ein elastisch verformbares Substrat mit einer Oberfläche aus einem organischen Natur- und/oder Kunststoff zur Verfügung gestellt, eine Haftvermittlerschicht auf dem Substrat aufgebracht und eine harte Funktionsschicht aufgebracht, deren Bruchdehnung geringer ist als diejenige des Substrates.

Vorzugsweise wird die Haftvermittlerschicht und/oder die Funktionsschicht mittels Physical Vapor Deposition (PVD) aufgebracht. Vorteilhafterweise werden die Haftvermittlerschicht und die Funktionsschicht nacheinander in derselben Anlage aufgebracht.

Das erfindungsgemässe Substrat mit Funktionsschicht hat den Vorteil, dass es elastische Substrate mit harten Funktionsschichten zur Verfügung stellt, die bisher nicht verfügbar waren. Aus der Vielzahl von neuen Produkten sind im Folgenden einige Einzelbeispiele aufgezählt: Latexhülle mit einer reibungsmindernden Schicht, Dichtringe mit einer reibungs- und verschleissmindernden Schicht auf den Laufflächen, medizinische Instrumente wie beispielsweise Katheter mit einer Beschichtung mit verbesserten Gleiteigenschaften unter Beibehaltung der gewünschten mechanischen Eigenschaften des Katheters, medizinische Instrumente mit einer Deckschicht, welche eine dunkle reflexmindernde Färbung aufweist, Elastomerteile mit einer körperverträglichen und/oder blutverträglichen Beschichtung für lmplantate, faserverstärkte Kunststoffe mit einer reibungsmindernden Schicht und/oder einer körperverträglichen Schicht für medizinische lmplantate und viele andere mehr.

Bei dem erfindungsgemässen Substrat mit Funktionsschicht ist die Bruchdehnung der Funktionsschicht geringer als diejenige des Substrates. Weil jedoch die Haftung der Funktionsschicht auf dem Substrat dank einer geeigneten Haftvermittlerschicht sehr gut ist, reisst die Funktionsschicht zwar bei Dehnung, löst sich aber nicht ab. Bei Rückkehr aus dem gedehnten in den relaxierten Zustand schliessen sich die Risse der Funktionsschicht und es entsteht wieder eine geschlossene Oberfläche, sodass die Funktionsschicht weiter funktionsfähig ist. Dieser Lösungsansatz, welcher dem erfindungsgemässen Substrat mit Funktionsschicht zu Grunde liegt, ermöglicht eine Vielzahl neuer Produkte.

Weitere vorteilhafte Ausführungsformen gehen aus den abhängigen Ansprüchen und der Zeichnung hervor.

Im Folgenden wird die Erfindung an Hand des Ausführungsbeispiels und an Hand der Zeichnung näher erläutert. Es zeigen:
- Fig. 1a: eine Ausführungsform eines erfindungsgemässen Substrates mit Funktionsschicht in deformiertem Zustand,
- Fig. 1b: das Substrat mit Funktionsschicht von Fig. 1 a in relaxiertem Zustand, und
- Fig. 2: ein Ausführungsbeispiel mit einem Substrat mit Funktionsschicht gemäss vorliegenden Erfindung.

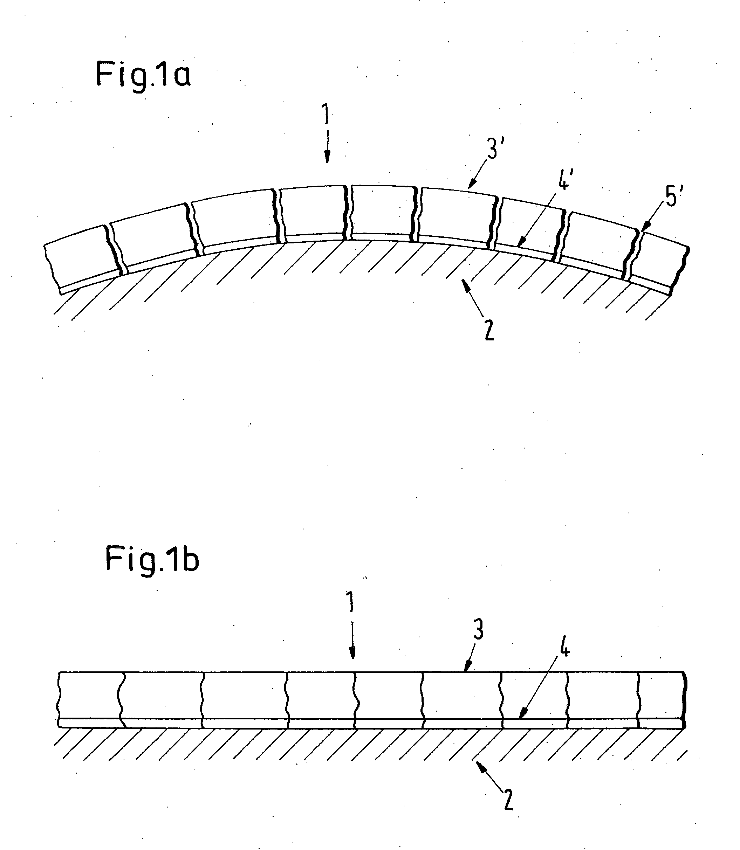

Die Figuren 1a und 1b veranschaulichen das Verhalten eines erfindungsgemässen Substrates mit Funktionsschicht. Da die Bruchdehnung der Funktionsschicht 3, 3' geringer als diejenige des Substrates 2, entstehen bei einer Dehnung des Substrates Risse 5' in der Funktionsschicht 3, 3'. Weil jedoch die Haftung der Funktionsschicht auf dem Substrat dank einer geeigneten Haftvermittlerschicht 4, 4' sehr gut ist, reisst die Funktionsschicht zwar bei Dehnung, löst sich aber nicht ab. Bei Rückkehr aus dem gedehnten in den relaxierten Zustand schliessen sich die Risse der Funktionsschicht und es entsteht wieder eine geschlossene Oberfläche, sodass die Funktionsschicht weiter funktionsfähig ist. ln den untersuchten Fällen von dünnen Schichten mit vielen Rissen im Submikrometerbereich ist die Funktionalität der Funktionsschicht erhalten geblieben. Eine weitere Ausführungsform bilden Funktionsschichten mit kolumnaren Strukturen, bei denen die Risse bereits strukturell vorgegeben sind.

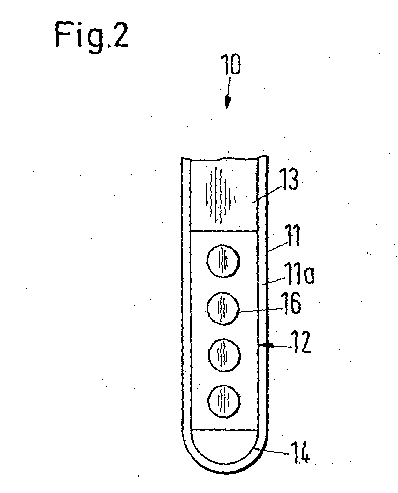

Im Ausführungsbeispiels, welches in Fig. 2 gezeigt ist, wird eine Ultraschallmessonde 10 beschrieben, die für medizinische Untersuchungen eingesetzt werden kann. Die Ultraschallmessonde 10 umfasst einen rotierenden Sondenteil 12 mit Ultraschallgebern 16, der in mit rund 1000 Umdrehungen pro Minute in einer flexiblen Latexhülle 11 rotiert. Die Latexhülle 11 ist auf der Innenseite mit einer reibungsmindernden Schicht 11a versehen. Die Ultraschallsonde 10 umfasst zusätzlich einen nicht rotierenden Sondenteil 14 sowie eine ebenfalls nicht rotierende Halterung 13.

Am Beispiel der flexiblen Latexhülle 11 mit der reibungsmindernden Schicht 11a werden die Eigenschaften und die Herstellung eines erfindungsgemässen Substrates mit Funktionsschicht im Detail erläutert. Bei der Latexhülle 11 handelt es sich um ein sehr elastisches Substrat mit einer Bruchdehnung von grösser als 500 % und einem Elastizitätsmodul von 0.1 GPa. Die reibungsmindernde Schicht 11a von 1 µm Dicke besteht im Ausführungsbeispiel aus Diamondlike Carbon (DLC), das eine Bruchdehnung von kleiner als 0.5% und ein Elastizitätsmodul von vorzugsweise kleiner 900 GPa, typisch 200 bis 300 GPa, aufweist. Zwischen der reibungsmindernden Schicht 11a und dem Substrat ist eine Haftvermittlerschicht von 0.1 µm Dicke aufgebracht, die Kohlenwasserstoffketten auf der Substratseite und Diamondlike Carbon (DLC) auf der Seite der reibungsmindernden Schicht 11a enthält sowie einen graduellen Übergang zwischen Kohlenwasserstoffketten und Diamondlike Carbon (DLC).

Da die reibungsmindernde Schicht 11a auf der Innenseite der Latexhülle 11 vorgesehen ist, wird die Latexhülle im Ausführungsbeispiel vor dem Aufbringen der Schicht 11 a gewendet, sodass die Innenseite der Latexhülle nach Aussen zu liegen kommt. Anschliessend wird auf dem Substrat mittels Physical Vapor Deposition (PVD), beispielsweise mittels Magnetron-Sputtern, die Haftvermittlerschicht und die reibungsmindernde Schicht aufgebracht. Dabei wird ein Graphit-Target als Plasmaquelle benützt unter gleichzeitiger Zugabe eines Kohlenwasserstoffgases, wie z.B. Azetylen. Auf der Oberfläche des Substrates findet bei anfänglich niedriger Energiedichte eine Plasmapolymerisation statt, wodurch die aufwachsende Schichte chemisch an das Substrat gebunden ist. Anschliessend kann die Energiedichte schrittweise oder gradiert erhöht werden und zur normalen Beschichtung mit Diamondlike Carbon (DLC) übergegangen werden. Im Ausführungsbeispiel besteht die Funktionsschicht aus DLC, sodass zwischen dem Aufbringen der Haftvermittlerschicht und der Funktionsschicht kein Wechsel des Targets erforderlich ist. Die fertig beschichtete Latexhülle 11 des Ausführungsbeispiels wird nach dem Beschichten wieder gewendet, sodass die reibungsmindernde Schicht 11a auf die Innenseite der Latexhülle zu liegen kommt. Anschliessend werden die Sondenteile 12, 14 und die Halterung 13 in die Latexhülle 11 eingesetzt. In Praxisversuchen hat sich gezeigt, dass die Wirkung der reibungsmindernden Schicht 11a durch das Wenden der Latexhülle 11 nicht beeinträchtigt wird.

Bei der Latexhülle mit reibungsmindernder Schicht handelt es sich um ein konkretes Beispiel. Die Materialwerte für ein erfindungsgemässes Substrat mit Funktionsschicht liegen üblicherweise innerhalb folgender Grenzen:
Bruchdehnung des Substrates grösser 1 %, 2%, 5%, 10%, 50%, 100% oder 200%,
Elastizitätsmodul des Substrates kleiner 0.5 GPa, 2 GPa, 8Gpa oder 20 GPa,
Dicke der Haftvermittlerschicht 0.06 bis 0.2 µm oder 0.04 bis 0.4 µm,
Dicke der Funktionsschicht 0.05 bis 0.5 µm, 0.1 bis 2 µm oder 0.1 bis 10 µm,
Bruchdehnung der Funktionsschicht kleiner 1%, 2%, 5%, 10% oder 100%,
Elastizitätsmodul der Funktionsschicht grösser 100 GPa, 200 GPa, 400 GPa.

Vorzugsweise haftet die Haftvermittlerschicht derart auf dem Substrat, dass die Funktionsschicht nach Verformungen des Substrates weiter funktionsfähig ist, beispielsweise indem die Haftvermittlerschicht chemisch an das Substrat gekoppelt ist. Vorzugsweise umfasst die Haftvermittlerschicht Diamondlike Carbon (DLC). In einer bevorzugten Ausführungsform enthält die Haftvermittlerschicht Kohlenwasserstoffketten auf der Substratseite und Diamondlike Carbon (DLC) auf der Seite der Funktionsschicht sowie einen gradierten Übergang zwischen Kohlenwasserstoffketten und Diamondlike Carbon (DLC). Die Herstellung einer derartigen Haftvermittlerschicht ist oben stehend im Rahmen des Ausführungsbeispiels beschrieben worden. Die chemisch an die Substratoberfläche gebundene Haftvermittlerschicht hat eine ausgezeichnete Haftung.

Vorzugsweise sind die Funktionsschichten anorganisch aufgebaut und/oder umfassen zumindest einen der folgenden Stoffe:
- Diamondlike Carbon (DLC), beispielsweise
   . metallfreies DLC,
   . Metall-DLC wie z.B. Ti-DLC, Si-DLC, Cr-DLC, Ta-DLC, W-DLC oder
   . DLC mit weiteren Elementen wie z.B. N, O, Si, F, Al, B,
- Metalle, Metallverbindungen und -Legierungen, beispielsweise Ti, Al, Si, Mo, Ta, lr, TiAl, TiSi, AlSi, TiAlV, Stahl, B,
- eine der nachfolgend aufgeführten Verbindungen von Metallen, Metalllegierungen oder sonstigen Stoffen:
   . Oxid (-Oₓ) wie z.B. TiO₂ Ti₂O₃, ZrO₂, CeO₂, IrO₂, Al₂O₃, CrO₂, SiO₂,
   . Nitrid (-Nₓ) wie z.B. TiN, Si₃N₄, CrN, Ta N, BN, VN, AIN, TiAlN, ZrN, NbN, TiSiN,
   . Carbid (-Cₓ) wie z.B. TiC, SiC, TaC, CrC, VC, WC,
   . Oxinitrid (-NₓO_{y}) wie z.B. TiNO, TaNO, SiNO,
   . Carbonitrid (-CₓN_{y}) wie z.B. TiCN, TaCN, BCN, SiCN,
   . Oxicarbide (-CₓO_{y}) wie z.B. TiCO, TaCO, SiCO,
   . Sulfid (-Sₓ) wie z.B. MoS₂, Ti-MoS₂,
- Zusammensetzungen und Kombinationen von zwei und mehreren Schichten:
   . Multilayer wie z.B. TiN/NbN, TaN/NbN, TaN/CrN, TiN/TaN, TiN/CrN, TiN/Ti,
   . gradierte Bilayer wie z.B. TiC/TiN, gradierter Übergang DLC/Schicht für alle oben angeführten Schichten,
   . nanostrukturierte Schichten wie z.B. TiN/Si₃N₄, WC/Co Nanocluster,
- alle oben genannten Zusammensetzungen in unterschiedlichen Stöchiometrien, insbesondere auch in nicht stöchiometrischen Zusammensetzungen.
- Polymerschichten, Plasmapolymerschichten.

Weiter können alle oben genannten Schichten als Grundlage dienen für weitere Schichten, z. B. Sol-Gel-Schichten.

In einer bevorzugten Ausführungsform werden die Haftvermittlerschicht und die Funktionsschicht mittels Physical Vapor Deposition (PVD) aufgebracht. Falls die Funktionsschicht andere Stoffe als DLC enthält, muss zwischen dem Aufbringen der Haftvermittlerschicht und der Funktionsschicht das Target gewechselt werden.

Das erfindungsgemässen Substrat mit Funktionsschicht ermöglicht die Schaffung einer Vielzahl von neuen Produkten, die dank der Kombination von elastischem Substrat und harter Funktionsschicht überlegene Eigenschaften aufweisen.

## Patentansprüche

1. Substrat mit Funktionsschicht, umfassend ein Substrat (2) mit einer Oberfläche aus einem organischen Natur- und/oder Kunststoff, eine Funktionsschicht (3) und eine Haftvermittlerschicht (4) zwischen der Oberfläche des Substrates (2) und der Funktionsschicht (3), **dadurch gekennzeichnet, dass** das Substrat (2) elastisch verformbar ist, und dass die Funktionsschicht (3) als harte Schicht ausgeführt ist, deren Bruchdehnung geringer ist als diejenige des Substrates (2).

2. Substrat mit Funktionsschicht nach Anspruch 1, wobei das Substrat mit Funktionsschicht derart aufgebaut ist, dass die Funktionsschicht (3) nach Verformungen des Substrates (2) weiter funktionsfähig ist.

3. Substrat mit Funktionsschicht nach einem der Ansprüche 1 oder 2, wobei die Bruchdehnung der Funktionsschicht (3) mindestens um einen Faktor 3 kleiner ist als diejenige des Substrates (2) und/oder wobei die Funktionsschicht kolumnar aufgebaut ist und lediglich eine minimale Bruchdehnung aufweist.

4. Substrat mit Funktionsschicht nach einem der Ansprüche 1 bis 3, wobei die Funktionsschicht (3) eine Dicke von 0.1 bis 10 µm hat.

5. Substrat mit Funktionsschicht nach einem der Ansprüche 1 bis 4, wobei die Funktionsschicht (3) im Wesentlichen anorganisch aufgebaut ist und/oder zumindest einen der folgenden Stoffe umfasst:
Diamondlike Carbon (DLC), Metalle, Metalllegierungen, oder Metalloxide, -nitride, -carbide, -oxinitride, -carbonitride, -oxicarbide oder - sulfide in unterschiedlichen Stöchiometrien sowie Bilayer mit gradiertem Übergang oder Multilayer.

6. Substrat mit Funktionsschicht nach einem der Ansprüche 1 bis 5, wobei die Haftvermittlerschicht (4) eine Dicke von 0.04 bis 0.4 µm hat.

7. Substrat mit Funktionsschicht nach einem der Ansprüche 1 bis 6, wobei die Haftvermittlerschicht (4) derart auf dem Substrat (2) haftet, dass die Funktionsschicht (3) nach Verformungen des Substrates (2) weiter funktionsfähig ist.

8. Substrat mit Funktionsschicht nach einem der Ansprüche 1 bis 7, wobei die Haftvermittlerschicht chemisch an das Substrat gekoppelt ist.

9. Substrat mit Funktionsschicht nach einem der Ansprüche 1 bis 8, wobei die Haftvermittlerschicht (4) Diamondlike Carbon (DLC) umfasst.

10. Substrat mit Funktionsschicht nach einem der Ansprüche 1 bis 9, wobei die Haftvermittlerschicht (4) Kohlenwasserstoffketten auf der Substratseite und Diamondlike Carbon (DLC) auf der Seite der Funktionsschicht (3) enthält sowie einen gradierten Übergang zwischen Kohlenwasserstoffketten und Diamondlike Carbon (DLC).

11. Verfahren zum Herstellen eines Substrates mit Funktionsschicht, **dadurch gekennzeichnet,**
**dass** ein elastisch verformbares Substrat (2) mit einer Oberfläche aus einem organischen Natur- und/oder Kunststoff zur Verfügung gestellt wird,
**dass** eine Haftvermittlerschicht (4) auf dem Substrat (2) aufgebracht wird, und
**dass** eine harte Funktionsschicht (3) aufgebracht wird, deren Bruchdehnung geringer ist als diejenige des Substrates (2).

12. Verfahren nach Anspruch 11, wobei die Haftvermittlerschicht (4) und/oder die Funktionsschicht (3) mittels Physical Vapor Deposition (PVD) aufgebracht wird.
